# EUROPEAN PATENT APPLICATION

(11) **EP 2 388 830 A1**
(43) Date of publication of application: **23.11.2011**
(21) Application number: 10382129.4
(22) Date of filing: 20.05.2010
(51) Int. Cl.: H01L 31/048, H01L 31/18

(54) **Photovoltaic modules and method of manufacture thereof**

(71) Applicant: Fundacion Inasmet, 20009 San Sebastián (Guip zcoa) (ES)
(72) Inventor: Arrizabalaga Canellada, Igor, 20009, San Sebastian (ES); Cano Iranzo, Francisco, Jesús, 20009, San Sebastian (ES); Garcia Arrieta, Sonia, 20009, San Sebastian (ES); Zubillaga Alcorta, Oihana, 20009, San Sebastian (ES); Machado Garcia, Maider, 20009, San Sebastian (ES)
(74) Representative: Carpintero Lopez, Francisco

(57) **Abstract**

The invention relates to a method of manufacture and a photovoltaic module made up of at least one photovoltaic cell and its corresponding electrical connections, and a composite comprising a matrix of thermosetting polymer resin, fiberglass reinforcing elements, the fiberglass being in fabric form previously treated for its subsequent transparency after the impregnation with a resin, at least in the front part of the cell, and in which the photovoltaic cell is completely embedded in the composite. This allows the module to be self-supporting and simplifies the method of manufacture.

## Description

### Field of the Invention

The present invention applies to photovoltaic modules. More specifically, it relates to a manufacturing process for manufacturing photovoltaic modules by means of composite materials or composites (fiber-reinforced resins) and to a module thus produced.

### Background of the Invention

The materials forming photovoltaic modules must assure suitable aging and durability against the action of external agents to which the assembly is exposed, such as environmental humidity, water, UV radiation, particle abrasion, impact of objects or others. At the same time, the materials forming the photovoltaic module must have sufficient structural capacity to assure a correct mechanical behavior thereof, providing the assembly with rigidity and mechanical strength, and assuring an optimal efficiency, for which it is necessary for the encapsulating materials to have sufficient transparency, and for the latter to be maintained over time in an acceptable degree.

Conventional solutions are based on thermoplastic polymers, typically EVA or PVB, with a rigid support or base made of either glass, metal or also based on thermoplastic polymers such as TEDLAR, PMMA or PUR, and a covering material made of glass or thermoplastic polymer. An example of this type of solution is the invention described in patent US2006207646, in which the cells are embedded with a silicone, using an additional rigid glass or plastic base and rigid transparent glass covering for protection, sealing and mechanical properties, whereas in patents US6113718 and WO975013 there are also support elements on both sides of the cells and the embedding thereof.

The photovoltaic integration in applications such as building and urban environment, transport means or low-power electrical appliances demands other features such as aesthetics, transparency, adaptation to various geometries, additional mechanical performance and low weight. The demand for these properties is due to the multifunctionality that the modules must have, since in addition to generating power they must comply with other functionalities demanded from the conventional elements (envelopment, heat and sound insulator, shade generator, solar filter, etc.) that they replace.

The use of transparent materials based on glass-reinforced and laminated thermosetting resins for the encapsulation of optoelectronic components or as a support or substrate thereof is known in the state of the art. This is the case of patent JP2006176586, in which a multi-phase structure (encapsulant of the device and substrate) is disclosed. However, in these processes the multi-phase structure leads to devices with a considerable weight, makes additional perimetric tightness and sealing necessary and limits obtaining planar components. Known encapsulations are not self-supporting (capable of supporting their own weight without additional support elements) and lack geometric flexibility in terms of their capacity to adopt different geometries (possibility of obtaining non-planar elements).

Patent application JP 11068136 describes a photovoltaic module produced by means of an injection molding process with polyurethane resin. However, said module does not have the desired features in relation to protection and support.

There are patents (US2004132867, US2007128376, US2007042168, CN101404297, DE4424801) which describe the use of fiber-reinforced thermosetting resin composites as a support. However, the transparency of the cell is compromised by means of the processes described in these patents.

Patent JP1099264 mentions the embedding of solar cells with non-reinforced resin; therefore it requires additional support elements which confer a structural character to the assembly.

### Object of the Invention

The present invention differs from known processes and products in that the module is manufactured by means of a composite (fiberglass-reinforced resin) which, being transparent, confers the assembly the structural and mechanical properties necessary for the direct application thereof, the cells and the reinforcing fibers being completely embedded by the resin.

The photovoltaic module described in the present invention solves aspects of structural capacity, transparency, adaptability to non-planar geometries, protection, weight and reduction of stages in the manufacturing process, with respect to known techniques. By means of using a composite material, in which the cells and their connections are completely embedded, the need to use additional materials as a base or covering is eliminated.

The method of manufacture of the invention comprises the following steps:
a. placing a fiberglass reinforcing element, previously treated for its subsequent transparency after the impregnation with a resin, at least in the front face of the cell or cells
b. molding a thermosetting resin such that the cell and the fibers are completely embedded.

The molding process can be performed by means of the vacuum bag infusion of the resin or by means of injecting the resin into a mold. Alternatively, the molding is performed by manual impregnation. The reinforcing elements can be dry fibers. The molding can also be performed by means of using vacuum bag prepreg technology, optionally incorporating a subsequent autoclave curing phase. Before the molding with resin, aramid fibers, carbon fibers, boron fibers or a combination thereof can be placed in the rear face of the cell or cells. The module thus produced comprises at least one photovoltaic cell and its corresponding electrical connections, and a composite comprising a matrix of thermosetting polymer resin, fiberglass reinforcing elements, the fiberglass being previously treated for its subsequent transparency after the impregnation with a resin, at least in the front part of the cell. The photovoltaic cell is completely embedded in the composite. The resin is a polyester resin, epoxy resin, vinylester resin or other transparent ones. Such resin can comprise one or several additives for additional functionalities, such as improvement of mechanical properties, improvement of resistance against environmental agents, coloring, filtering and conversion of incident wavelengths, or others. One of the surfaces of the manufactured module can have different finishes, textures and degrees of roughness. It can also incorporate a finish layer in the surfaces, based on gel-coat or top-coat, for the improvement of the surface properties of the module, such as abrasion and wear resistance, surface hardness, aging against environmental agents, or others.

### Brief Description of the Drawings

For the purpose of aiding to better understand the features of the invention according to a preferred practical embodiment thereof, a figure is attached to the following description, in which a module according to the invention has been depicted with an illustrative character.

### Detailed Description of the Invention

The present invention is based on using composite materials with a matrix of thermosetting polymer resins and fiberglass reinforcements, as an embedding material for photovoltaic cells. It is thus possible to obtain a protective and support material for the cell with suitable rigidity and specific strength (high rigidity and reduced weight). Thus, the different features mentioned: structural capacity, transparency, protection, sealing and tightness, geometric flexibility, weight reduction and easy assembly and integration to various substrates, are thus achieved with a single material.

The modules (see figure) are manufactured by means of a single process, in which the assembly of interconnected photovoltaic cells or of a cell and its corresponding electrical connections is embedded by the protective and support material in a single step, without needing to add other supports or coverings to the module.

A composite material, with a matrix of transparent thermosetting resin and fiberglass reinforcement, has been selected. For the resin, various additives can be used for the improvement of properties, both of mechanical strength and resistance against external environmental agents. For the reinforcement, glass fibers previously subjected to a treatment, due to which they are transparent after the impregnation with the resin, are selected. A composite material is thus obtained which has an excellent finish, transparency, high rigidity and strength values and which offers suitable protection against external environmental conditions for the application in question, it not being necessary to provide additional materials which confer said mechanical properties or specific sealants.

The modules are manufactured by means of a single process, in which the composite material acts as a base and covering mentioned in other patents. The module encapsulated in the composite of the invention is obtained by means of embedding the photovoltaic cells (2) and their connections (3) with the thermosetting composite. To obtain it, a fiberglass laminate (4), in which the fiber reinforcement has been subjected to a prior treatment whereby it is transparent after its impregnation, is placed in the front part of the cell or assembly of interconnected cells (the part which will face the solar radiation when the cell is operating) and other laminate (5) in the rear part, which can also include glass fibers of the type described above (previously treated to provide them with transparency after the impregnation) or another type of fibers such as aramid fibers, carbon fibers, glass fibers, etc., thus forming a fiber-cell-fiber sequence. Once processed, this assembly will form the photovoltaic module (1).

The processes used for that purpose are vacuum bag infusion, RTM (Resin Transfer Molding), manual lamination or lamination by means of prepregs. Each of the mentioned processes is described below:
Vacuum bag infusion: this process consists of molding composites by means of introducing resin in a cavity previously created between the mold and a vacuum bag or film sealing the actual cavity with respect to the exterior. The resin enters by the action of a vacuum pressure inside this cavity. Before the infusion of the resin, the fiber reinforcement (with treatment, for subsequent transparency, at least in the front part of the cell or cells), as well as the interconnected cells and other electrical connections (or the cell and its connections if the module is made up of a single cell) to be encapsulated by the composite, arranged such that the cells are positioned between layers of fiber on both sides thereof, is placed in the mentioned cavity. The resin, premixed and degassed in an external container, is infused and fills the cavity, flowing through the fiber reinforcement and around the cells. Once the cavity is full, the vacuum is maintained for the time necessary for the curing and solidification of the resin. Once cured, the module is demolded.
RTM-resin transfer molding: this process consists of molding by means of injecting resin inside a closed mold, inside which the fibers-interconnected cells-fibers assembly is placed as in the previous example. Once the mold is closed, the resin is introduced inside this mold by means of a pressure injection. There is a flow of resin which advances through the fiber and around the photovoltaic cells, embedding them. Once the correct filling of the cavity is assured, the resin is cured and the photovoltaic module is subsequently demolded.
Manual lamination: This process consists of placing the fiber reinforcement in dry form, the fiber being manually impregnated with resin. The layers of fiberglass and the interconnected cells, forming an assembly of layers of fiber on both sides of the cells, are arranged on a lower mold. The impregnation of the fiber is carried out by using manual methods and by means of using tools such as impregnation rollers, brushes or others. A vacuum bag is subsequently manufactured on the mentioned laminate and the cavity is closed with a sealing material. If the curing of the resin requires it, this assembly is introduced in an oven in which the conditions necessary for the curing and compaction of the laminate are applied, according to the type of resin used. These conditions can be vacuum and temperature, determined by the curing cycle of the resin. According to the resin system used, the curing can be carried out under vacuum and room temperature conditions. Once the resin has solidified, the photovoltaic module is demolded.
Lamination by means of prepregs: the main difference of this composite molding process from the two mentioned above is that the fiber used is not a dry fabric, but rather it is previously preimpregnated with the already premixed resin. The prepreg and the interconnected cells are arranged forming an assembly of preimpregnated fibers on both sides of the cells on a lower mold and using a vacuum bag system, the cavity is closed with a sealing material. This assembly is introduced in an autoclave or in an oven, in which the conditions necessary for the curing and compaction of the laminate are applied, according to the type of resin used. These conditions can be pressure, vacuum and/or temperature, determined by the curing cycle of the resin. According to the resin system used, the curing can be carried out under vacuum and room temperature conditions. Once the resin has solidified, the photovoltaic module is demolded.

Finally, these processes offer the possibility of obtaining a finish with a different roughness or texture of the encapsulating composite materials, contributing to an improvement in the energy conversion efficiency of the module.

The final features of the module embedded in composites, added to the features typical of the described obtaining processes allow, on one hand, obtaining the photovoltaic module by means of a single manufacturing process (which can be vacuum bag infusion, RTM, manual lamination or lamination by means of prepregs), it not being necessary to add several independent processes for lamination, application of the protective layer, sealing and obtaining mechanical properties of the photovoltaic panel, as would be the case of the current modules mentioned above, and on the other hand, the self-supporting nature of the integrated module obtained makes it unnecessary to use frames, thus preventing subsequent processes for placing these holding frames. On the other hand, the molding processes by means of which said modules are manufactured allow the desining of tooling such that the resulting components can have various geometries that are not necessary planar.

The versatility for molding composite materials with which this new photovoltaic module is being developed allows the integration of these modules, if necessary, on different substrates or support materials, made of metal, composite, etc., as well as the direct integration in components or parts belonging to the final application of use of the photovoltaic system.

The present invention has the possibility of incorporating a finish layer in the surfaces, based on gel-coat or top-coat, for the improvement of the surface properties of the module, such as abrasion and wear resistance, surface hardness, aging against environmental agents, or others.

The invention furthermore has the possibility of using additives in the resin, by means of which it is possible to alter or modify various properties thereof and, therefore, the end product. Examples of modification of the resin comprise the improvement of properties, both of mechanical strength and resistance against external environmental agents, the pigmentation thereof, whereby it is possible to obtain a colored module, contributing to the required aesthetic appearance, or a colored and at the same partially translucent module, as well as the addition of additives which act as modifiers of the incident wavelengths, converting the latter into wavelengths which can be used by the cells and thus increasing the efficiency of the resulting module.

The module manufactured by means of the processes of the invention can have different finishes, textures and degrees of roughness.

It furthermore has the following advantages:
- the machining of the modules is possible, compared to the impossibility of machining the tempered glass used today;
- it is easier to incorporate anchors;
- customized sizes and geometries can be manufactured;
- the weight is reduced.

The product object of this invention can be extended to the applications mentioned below:
- solar farms and industrial and rural installations isolated from the network;
- building and street furniture (residential, commercial and industrial buildings; lighting, signs, shelters, etc.);
- greenhouses;
- transport: aeronautical, automobile, railway, marine transport, etc.;
- space applications;
- low-power electrical appliances and consumption products: mobile phones, laptop computers, PDAs, etc.

### Description of Preferred Embodiments

### Example 1: Curved module for a constructive roof element, with a curved geometry, with spherical crystalline silicon photovoltaic cells connected forming a flexible grid.

Dimensions of the module:
- Perimeter or arc length: 1500 mm
- Radius of curvature: 2865 mm
- Arc of curvature: 30°
- Thickness: 12 mm

The module is a monolithic structure, the manufacture of which by means of a vacuum bag infusion process requires the following materials:
- Transparent isophthalic polyester resin.
- Finish of 300 µm of transparent polyester gel-coat.
- Fabric form fiberglass reinforcement, according to the following characteristics and arrangement:
   o 1 layer of fabric for infusion with an areal weight of 200 g/m², with specific treatment for manufacturing transparent composite, in the front part of the photovoltaic (PV) cells.
   o 8 layers of fabric for infusion with an areal weight of 1000 g/m² in the rear part after the PV cells.

The layer of gel-coat is projected onto a metallic tool, the surface of which is mirror polished. The layer of fiberglass fabric reinforcement with an areal weight of 200 g/m² with TF970 treatment, from Hexcel, is subsequently placed, on which the grid of PV cells and the corresponding electrical connections to the exterior are positioned. The 8 layers of fiberglass fabric with an areal weight of 1000 g/m² are then placed, after which a peel-ply is arranged. Finally, the vacuum bag is prepared, after which the resin is infused. After the curing thereof, the panel is removed from the mold.

The module is then machined at the edges for the purpose of obtaining the definitive dimensions and tolerances, as well as for placing therein anchors for its subsequent assembly as a roof element.

### Example 2: Curved module for a constructive roof element, with flexible cells manufactured with CIGS technology.

A module for a constructive roof element, with a curved geometry, with flexible photovoltaic cells manufactured by CIGS technology.

Dimensions of the module:
- Length : 1500 mm
- Radius of curvature: 2865 mm
- Arc of curvature: 30°
- Thickness: 12 mm

The module is a monolithic structure, the manufacture of which by means of a vacuum bag infusion process requires the following materials:
- Transparent isophthalic polyester resin.
- Finish of 300 µm of transparent polyester gel-coat.
- Fabric form fiberglass reinforcement, according to the following characteristics and arrangement:
   o 1 layer of fabric for infusion with an areal weight of 200 g/m², with specific treatment for manufacturing transparent composite, in the front part of the PV cells.
   o 8 layers of fabric for infusion with an areal weight of 1000 g/m² in the part after the PV cells.

The layer of gel-coat is projected onto a metalllic tool, the surface of which is mirror polished. The layer of fiberglass fabric reinforcement with an areal weight of 200 g/m² with TF970 treatment, from Hexcel, is subsequently placed, on which the flexible photovoltaic cells and the corresponding electrical connections to the exterior are positioned. The 8 layers of fiberglass fabric with an areal weight of 1000 g/m² are then placed, after which a peel-ply is arranged. Finally, the vacuum bag is prepared, after which the resin is infused. After the curing thereof, the panel is removed from the mold.

The module is then machined at the edges for the purpose of obtaining the definitive dimensions and tolerances, as well as for placing therein anchors for its subsequent assembly as a roof element.

### Example 3: Module for a greenhouse roof.

Photovoltaic module for a greenhouse roof, with a planar geometry, formed by planar crystalline silicon photovoltaic cells.

Dimensions of the module:
- Length: 500 mm
- Width: 500 mm
- Thickness: 15 mm

The module is a monolithic structure, the manufacture of which by means of an RTM process requires the following materials:
- Transparent isophthalic polyester resin.
- Finish of 300 µm of transparent polyester gel-coat
- Fabric form fiberglass reinforcement, according to the following characteristics and arrangement:
   o 1 layer of fabric for infusion with an areal weight of 200 g/m², with specific treatment for manufacturing transparent composite, in the part before the PV cells.
   o 10 layers of fabric for infusion with an areal weight of 1000g/m², with specific treatment for manufacturing transparent composite, in the part after the PV cells.

The layer of gel-coat is projected onto a metallic tool, the surface of which is mirror polished. The layer of fiberglass fabric reinforcement with an areal weight of 200 g/m² is subsequently placed, on which the interconnected photovoltaic cells and the corresponding electrical connections to the exterior are positioned. The 8 layers of fabric with an areal weight of 1000 g/m² are then placed. This assembly of materials additionally has a perimetric space of 20 mm in width free of PV cells, in which the anchors are placed for fixing it to the structure bearing the roof of the greenhouse. Finally, the mold is closed, after which the resin is injected into the cavity thereof. After the curing of the resin, the module is removed from the mold.

### Example 4: Module for an airplane wing.

The photovoltaic module will form part of an airplane wing manufactured by means of a hollow structure, of which the module forms the upper skin of said structure and, therefore, of the wing. The module is formed by spherical crystalline silicon photovoltaic cells connected forming a flexible grid.

Dimensions of the module:
● Length: 1200 mm
● Width: 300 mm
● Thickness: 1.5 mm
● Geometry: airplane wing section

The structure of the module is made up of the following materials:
● Finish of 300 µm of transparent epoxy gel-coat
● Epoxy resin prepreg:
   o 2 layers of 100 g/m² epoxy/fiber glass prepreg, with TF970 fabric, from Hexcel, treated for manufacturing transparent composite, in the part before the PV cells.
   o 2 layers of 100 g/m² epoxy/fiber glass prepreg, with TF970 fabric, from Hexcel, treated for manufacturing transparent composite, in the rear part of the PV cells.
   o 5 layers of 250 g/m² epoxy/carbon fiber prepreg, in the rear part of the PV cells, after the epoxy/glass prepreg.

The module is manufactured by means of a vacuum bag preimpregnation process on a metal mold with a mirror polished surface. The layer of gel-coat is projected and the preimpregnated laminate and the grid of spherical cells are placed, assuring that the electrical connections come out of the laminate. The vacuum bag is prepared and it is cured in an oven. After the curing thereof, the module is removed from the mold.

### Example 5: Module for a sunroof with application in the automotive sector.

Module for a sunroof with application in the automotive sector formed by planar crystalline silicon photovoltaic cells.

Dimensions of the modules:
● Length: 1600 mm
● Width: 1200 mm
● Thickness: 4 mm

The module has interconnected cells distributed in the entire area except in a 20 mm perimetric frame, which is left free of cells for the location of elements for tightness and integration of the panel to the rest of the structure of the vehicle.

The structure of the module, manufactured by means of RTM, is made up of the following materials:
● Transparent epoxy resin
● Finish of 300 µm of transparent epoxy gel-coat
● Fabric form fiberglass reinforcement, according to the following characteristics and arrangement:
   o 2 layers of 125 glm² fabric, with specific treatment (TF970, from Hexcel) for manufacturing transparent composite, in the part before the PV cells.
   o 4 layers of 800 g/m² fabric, with specific treatment for manufacturing transparent composite, in the part after the PV cells.

The module is manufactured on a metal mold incorporating inner resistances for the heating thereof, with both surfaces of the cavity being mirror polished. The layer of gel-coat is applied by means of an aerosol and the layers of fabric and the interconnected photovoltaic cells are placed, assuring that the electrical connections come out of the laminate. The mold is closed and the epoxy resin, to which a pigment has been previously added, is injected with an injection pressure of 2 bars. Finally, the laminate is cured by means of the heating resistances of the mold itself, a colored and translucent module being obtained. After the curing, the module is demolded.

### Example 6: Planar module for a non-ventilated façade.

A facing module for a non-ventilated façade, with a planar geometry, with planar crystalline silicon photovoltaic cells.

Dimensions of the module:
- Length: 2000 mm
- Width: 1000 mm
- Thickness: 12 mm

The module is a monolithic structure, the manufacture of which by means of a vacuum bag infusion process requires the following materials:
- Transparent isophthalic polyester resin
- Finish of 300 µm of transparent polyester gel-coat
- Fabric form fiberglass reinforcement, according to the following characteristics and arrangement:
   o 1 layer of fabric for infusion with an areal weight of 125g/m², with specific treatment for manufacturing transparent composite, in the front part of the PV cells.
   o 8 layers of fabric for infusion with an areal weight of 1000 g/m² in the part after the PV cells.

The layer of gel-coat is projected onto a metallic tool, the surface of which is mirror polished. The layer of fiberglass fabric reinforcement with an areal weight of 125 g/m², on which the interconnected PV cells and the corresponding electrical connections to the exterior are positioned, is placed. Finally, the 8 layers of fiberglass fabric with an areal weight of 1000 g/m² are placed and the vacuum bag is prepared, after which the resin is infused. After the curing thereof, the module is demolded, after which it is machined for its cutting, for the purpose of obtaining the definitive dimensions and tolerances, as well as for placing therein anchors for its subsequent assembly in the façade substructure section by means of mechanical anchors.

### Example 7: Module for a space application.

A photovoltaic module for a space application, with a planar geometry, with gallium arsenide (GaAs) photovoltaic cells.

Dimensions of the module:
● Length: 500 mm
● Width: 500 mm
● Thickness: 4 mm
● Geometry: the module is planar

The module is formed by the following materials:
● Finish of 300 µm of transparent epoxy gel-coat
● Epoxy resin prepreg:
   o 2 layers of 125 g/m² epoxy/glass, with treated fibers (TF970, from Hexcel) for manufacturing transparent composite and resin modified with additives which filter and modify the wavelength of the incident radiation, in the part before the PV cells.
   o 2 layers of 125 g/m² epoxy/glass prepreg, with treated fibers (TF970, from Hexcel) for manufacturing transparent composite and resin modified with additives which filter and modify the wavelength of the incident radiation, in the part after the PV cells. o 4 layers of 200 g/m² epoxy/carbon prepreg, in the part after the PV cells, after the epoxy/glass composite.

The layer of gel-coat is projected onto a planar mold and the laminate and the interconnected cells are placed, assuring that the electrical connections come out of the laminate. A vacuum bag is prepared and the laminate is compacted and cured by means of an autoclave cycle. After the curing, the module is demolded.

This module can be used as the skin of sandwich type panels which can in turn be multifunctional, having heat dissipation and electromagnetic filter properties.

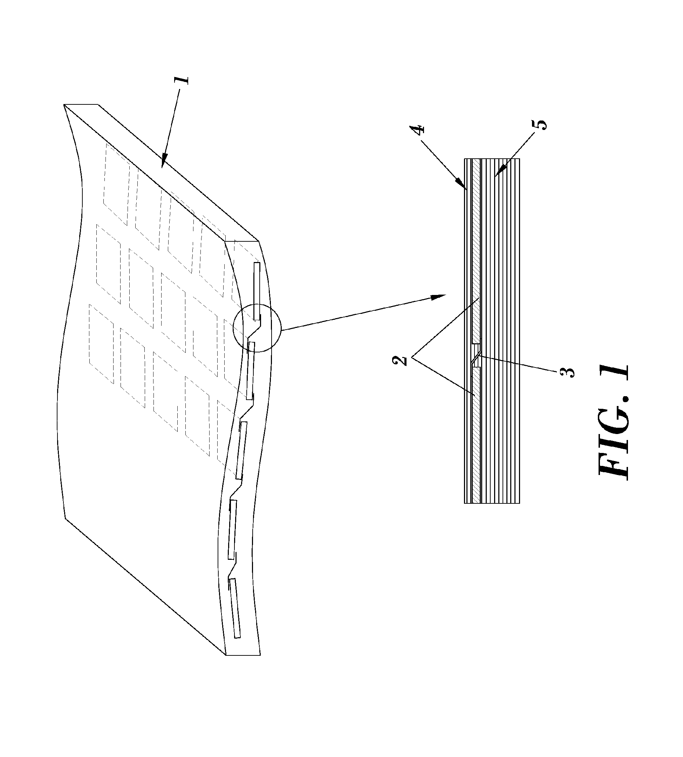

## Claims

1. Method of manufacture of photovoltaic modules provided with at least one photovoltaic cell with electrical connections, **characterized in that** it comprises the following steps:
a. placing a fiberglass reinforcing element, previously treated for its subsequent transparency after the impregnation with a resin, at least in the front face of the cell or cells
b. molding a thermosetting resin such that the cell and the fibers are completely embedded.

2. Method according to claim 1, **characterized in that** the molding process is performed by means of the vacuum bag infusion of the resin.

3. Method according to claim 1, **characterized in that** the molding is performed by means of injecting the resin into a mold.

4. Method according to claim 1, **characterized in that** the molding is performed by manual impregnation.

5. Method according to any of the previous claims, **characterized in that** the reinforcing elements are dry fibers.

6. Method according to claim 1, **characterized in that** the molding is performed by means of using vacuum bag prepreg technology.

7. Method according to claim 6, **characterized in that** it incorporates a subsequent autoclave curing phase.

8. Method according to any of the previous claims, **characterized in that** before the molding with resin aramid fibers, carbon fibers, boron fibers, or other fibers, or a combination thereof are placed in the rear face of the cell or cells.

9. Photovoltaic module made up of at least one photovoltaic cell and its corresponding electrical connections, and a composite comprising a matrix of thermosetting polymer resin, fiberglass reinforcing elements, the fiberglass being in fabric form previously treated for its subsequent transparency after the impregnation with a resin, at least in the front part of the cell, **characterized in that** the photovoltaic cell is completely embedded in the composite.

10. Photovoltaic module according to claim 9, **characterized in that** it comprises in rear face aramid fibers, carbon fibers, boron fibers, or other fibers, or a combination thereof.

11. Photovoltaic module according to any of claims 9-10, **characterized in that** the resin is a polyester resin, epoxy resin, vinylester resin or other transparent ones.

12. Photovoltaic module according to any of claims 9-11, **characterized in that** the resin comprises one or several additives for additional functionalities, such as improvement of mechanical properties, improvement of resistance against environmental agents, coloring, filtering and conversion of incident wavelengths, or others.

13. Photovoltaic module according to any of claims 9-12, **characterized in that** one of the surfaces of the manufactured module can have different finishes, textures and degrees of roughness.

14. Photovoltaic module according to any of claims 9-13, **characterized in that** it incorporates a finish layer in the surfaces, based on gel-coat or top-coat, for the improvement of the surface properties of the module, such as abrasion and wear resistance, surface hardness, aging against environmental agents, or others.
